(19) Europäisches Patentamt
European Patent Office
Office européen des brevets

(11) EP 4 095 897 A1

(12) EUROPEAN PATENT APPLICATION
published in accordance with Art. 153(4) EPC

(43) Date of publication:
**30.11.2022 Bulletin 2022/48**

(21) Application number: **21744242.5**

(22) Date of filing: **19.01.2021**

(51) International Patent Classification (IPC):
***H01L 23/36*** (2006.01) ***H01L 23/373*** (2006.01)
***C08K 7/04*** (2006.01) ***C08L 101/00*** (2006.01)
***C09K 5/14*** (2006.01) ***C08K 3/013*** (2018.01)
***C08K 3/38*** (2006.01)

(52) Cooperative Patent Classification (CPC):
**C08K 3/013; C08K 3/38; C08K 7/04; C08L 101/00; C09K 5/14; H01L 23/36; H01L 23/373**

(86) International application number:
**PCT/JP2021/001728**

(87) International publication number:
**WO 2021/149690 (29.07.2021 Gazette 2021/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.01.2020 JP 2020006611**

(71) Applicant: **SEKISUI CHEMICAL CO., LTD.**
**Osaka-shi**
**Osaka**
**530-8565 (JP)**

(72) Inventors:
- **MIZUNO, Shohei**
  **Mishima-gun, Osaka 618-0021 (JP)**
- **KOUMA, Aki**
  **Mishima-gun, Osaka 618-0021 (JP)**
- **SHINJOU, Takashi**
  **Mishima-gun, Osaka 618-0021 (JP)**
- **SHIBUTA, Kaoru**
  **Mishima-gun, Osaka 618-0021 (JP)**

(74) Representative: **Ter Meer Steinmeister & Partner Patentanwälte mbB**
**Nymphenburger Straße 4**
**80335 München (DE)**

# (54) THERMALLY CONDUCTIVE SHEET, LAMINATE, AND SEMICONDUCTOR DEVICE

(57) A thermally conductive sheet has a thermally conductive resin composition layer, wherein the thermally conductive resin composition layer is made of a thermally conductive resin composition (1) including an inorganic filler and a binder resin (3). The inorganic filler includes a boron nitride particle (2), the content of the inorganic filler in the thermally conductive resin composition layer is 65% by volume or more, and the boron nitride particle (2) has an average aspect ratio of 7 or less, which is calculated from a major axis and a minor axis of a primary particle measured by a specific method. The thermally conductive resin composition layer has a thickness of 200 $\mu$m or less.

Fig.1

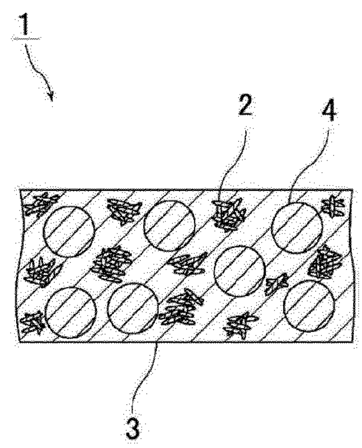




Processed by Luminess, 75001 PARIS (FR)

## Description

### Technical Field

The present invention relates to a thermally conductive sheet, a laminate, and a semiconductor device.

### Background Art

Power modules have been used in a wide variety of fields including industrial appliances, home appliances and information devices. For power modules, resin sheet has been attempted to be used as a substrate, and power modules in which resin sheet is used are expected to be used in high voltage applications. In such high voltage applications, it has been considered to use a substrate including boron nitride which has low dielectric constant as a heat-dissipating filler in order to obtain high voltage resistance.

For example, PTL 1 discloses a curable material which contains boron nitride as a heat-dissipating filler and is used for a substrate and the like, wherein two types of agglomerated particles having a different porosity are used as boron nitride (see PTL 1). PTL 1 discloses that both of the boron nitride particles have an average aspect ratio of 10 or more. PTL 1 also discloses a thermally conductive sheet prepared by using a curable material, wherein the curable material is applied to the sheet in a thickness of 350 μm.

Furthermore, PTL 2 discloses a resin composition film formed by using a resin composition comprising resin and a thermally conductive anisotropic filler, and a resin sheet comprising the resin composition film (see PTL 2). PTL 2 discloses a resin sheet applied to have a thickness of 200 μm.

### Citation List

### Patent Literature

PTL 1: JP 2018-82165 A
PTL 2: JP 2019-151754 A

### Summary of Invention

### Technical Problem

An object of the present invention is to provide a thermally conductive sheet comprising a filler comprising boron nitride particles, which can prevent reduction of insulation properties after heating in reflow soldering and the like even when the thermally conductive resin composition layer is as thin as 200 μm or less and the filler is densely filled.

### Solution to Problem

The present inventors have conducted intensive studies and as a result have found that insulating properties of a thermally conductive resin composition including a large amount of filler containing boron nitride particles may be reduced due to heating in reflow soldering and the like. The present inventors have investigated its cause and have found that the cause is cracks formed around boron nitride due to heating. A more detailed investigation has revealed that insulation properties are not reduced due to heating in reflow soldering and the like in conventional thermally conductive sheets having a thick thermally conductive resin composition layer as described in PTL 1 even when a large amount of filler is included at a content of 65% by volume or more. Meanwhile it has been found that when a large amount of filler is included at a content of 65% by volume or more and the thermally conductive resin composition layer is as thin as 200 μm as described in PTL 2, insulation properties are reduced after heating in reflow soldering and the like. A further study of the cause has shown that when the thermally conductive resin composition layer of a thermally conductive sheet is thin, the sheet is more likely to be affected by cracks formed in heating, and consequently insulation properties are reduced after heating in reflow soldering and the like.

The present inventors have found that when the thermally conductive resin composition layer is as thin as 200 μm or less and a large amount of filler is included at a content of 65% by volume or more, and a filler having high aspect ratio of primary particle size of boron nitride particles is used, insulation properties are reduced after heating in reflow soldering and the like. The present inventors have also found that even when the thermally conductive resin composition layer is as thin as 200 μm or less and a large amount of filler is included at a content of 65% by volume or more, reduction

of insulation properties after heating in reflow soldering and the like can be prevented by making the aspect ratio of the primary particle size of boron nitride particles smaller, and have completed the present invention.

The gist of the present invention is the following [1] to [21].

[1] A thermally conductive sheet comprising a thermally conductive resin composition layer, wherein the thermally conductive resin composition layer comprises an inorganic filler and a binder resin, the inorganic filler comprises a boron nitride particle, the content of the inorganic filler in the thermally conductive resin composition layer is 65% by volume or more, and the boron nitride particle has an average aspect ratio of 7 or less, which is calculated from a major axis and a minor axis of a primary particle measured by the following method, and the thermally conductive resin composition layer has a thickness of 200 μm or less:

(Method of measurement)

a cross-section in the thickness direction of the thermally conductive sheet is exposed by a cross-section polisher and the exposed cross-section is observed by a scanning electron microscope (SEM) at a magnification of 400 to 1,200 to obtain an observation image; in the observation image, the major axis and the minor axis of 200 random primary particles of the boron nitride particle in the thermally conductive resin composition layer are measured using an image processing software to calculate an aspect ratio of the respective particles from the major axis/ the minor axis, and an average of the 200 particles is determined as an average aspect ratio; the major axis refers to the length of the longest portion of the primary particle of the boron nitride particle observed in the observation image, and the minor axis is the length in the direction perpendicular to the direction of the major axis in the observation image.

[2] The thermally conductive sheet according to [1] above, wherein the thermally conductive resin composition layer comprises an inorganic filler other than the boron nitride particle.

[3] The thermally conductive sheet according to [2] above, wherein the inorganic filler other than the boron nitride particle is at least one selected from the group consisting of alumina, aluminum nitride, magnesium oxide, diamond and silicon carbide.

[4] The thermally conductive sheet according to [2] or [3] above, wherein the primary particle of the inorganic filler other than the boron nitride particle has an average aspect ratio of 3 or less.

[5] The thermally conductive sheet according to any one of [2] to [4] above, wherein the inorganic filler other than the boron nitride particle has an average particle size of 0.1 μm or more and 100 μm or less.

[6] The thermally conductive sheet according to any one of [2] to [5] above, wherein the content of the inorganic filler other than the boron nitride particle in the thermally conductive resin composition layer is 2% by volume or more and 60% by volume or less.

[7] The thermally conductive sheet according to any one of [1] to [6] above, wherein the content of the boron nitride particle in the thermally conductive resin composition layer is 15% by volume or more and 80% by volume or less.

[8] The thermally conductive sheet according to any one of [1] to [7] above, wherein the primary particle of the boron nitride particle has an average major axis measured in the cross-section of the thermally conductive resin composition layer of 1 μm or more and 20 μm or less.

[9] The thermally conductive sheet according to any one of [1] to [8] above, wherein the boron nitride particle comprises an agglomerated boron nitride particle.

[10] The thermally conductive sheet according to any one of [1] to [9] above, wherein the thermally conductive sheet has a thermal conductivity of 10 W/(m·K) or more.

[11] The thermally conductive sheet according to any one of [1] to [10] above, wherein the content of the inorganic filler is 80% by volume or less.

[12] The thermally conductive sheet according to any one of [1] to [11] above, wherein resin constituting the binder resin is a thermosetting resin.

[13] The thermally conductive sheet according to [12] above, wherein the thermosetting resin is cured by a curing agent.

[14] The thermally conductive sheet according to any one of [1] to [13] above, wherein the resin constituting the binder resin is at least one selected from the group consisting of an epoxy resin and a phenoxy resin.

[15] The thermally conductive sheet according to any one of [1] to [14] above, wherein the content of the binder resin in the thermally conductive resin composition layer is 10% by volume or more and 35% by volume or less.

[16] The thermally conductive sheet according to any one of [1] to [15] above, wherein the boron nitride particle has an average aspect ratio of 2 or more.

[17] A laminate comprising the thermally conductive sheet according to any one of [1] to [16] above, a metal base plate and a metal plate, wherein the laminate comprises the thermally conductive sheet and the metal plate on the metal base plate in this order.

[18] The laminate according to [17] above, wherein the laminate is a circuit board.

[19] The laminate according to [17] or [18] above, wherein the metal plate has a circuit pattern.

[20] A semiconductor device comprising the laminate according to any one of [17] to [19] above, and a semiconductor

element provided on the metal plate.

[21] A thermally conductive resin composition layer comprising an inorganic filler and a binder resin, wherein the inorganic filler comprises a boron nitride particle, the content of the inorganic filler in the thermally conductive resin composition layer is 65% by volume or more, and the boron nitride particle has an average aspect ratio of 7 or less, which is calculated from a major axis and a minor axis of a primary particle measured by the following method, and the thermally conductive resin composition layer has a thickness of 200 μm or less:

(Method of measurement)

a cross-section of the thermally conductive resin composition layer is exposed by a cross-section polisher and the exposed cross-section is observed by a scanning electron microscope (SEM) at a magnification of 400 to 1,200 to obtain an observation image; in the observation image, the major axis and the minor axis of 200 random primary particles of the boron nitride particle in the thermally conductive resin composition layer are measured using an image processing software to calculate an aspect ratio of the respective particles from the major axis/ the minor axis, and an average of the 200 particles is determined as an average aspect ratio; the major axis refers to the length of the longest portion of the primary particle of the boron nitride particle observed in the observation image, and the minor axis is the length in the direction perpendicular to the direction of the major axis in the observation image.

Advantageous Effects of Invention

The present invention can prevent reduction of insulation properties of a thermally conductive sheet including boron nitride particles after heating in reflow soldering and the like even when the thermally conductive resin composition layer is thin and a large amount of filler is included.

Brief Description of the Drawings

[Fig. 1] Fig. 1 is a schematic cross-sectional view illustrating a thermally conductive resin composition according to an embodiment of the present invention.

[Fig. 2] Fig. 2 is a schematic cross-sectional view illustrating a laminate according to an embodiment of the present invention.

[Fig. 3] Fig. 3 is a schematic cross-sectional view illustrating a semiconductor device according to an embodiment of the present invention.

Description of Embodiments

Hereinafter the present invention will be described with reference to embodiments.

<Thermally conductive resin composition layer>

The thermally conductive sheet of the present invention has a thermally conductive resin composition layer comprising a thermally conductive resin composition.

Referring to Fig. 1, the thermally conductive resin composition layer 1 according to the present invention comprises an inorganic filler comprising boron nitride particles 2 and a binder resin 3. The thermally conductive resin composition layer 1 may also include an inorganic filler 4 other than the boron nitride particle where necessary as described later. The inorganic filler 4 other than the boron nitride particle in the thermally conductive resin composition layer 1 shown in Fig. 1 is spherical, but the inorganic filler 4 other than the boron nitride particle may have any form as described later. The inorganic filler 4 other than the boron nitride particle may not be included therein. Furthermore, it is preferable that at least part of the boron nitride particles is agglomerated boron nitride particles.

In the thermally conductive resin composition layer according to the present invention, the content of the inorganic filler comprising boron nitride particles is 65% by volume or more, and the average aspect ratio calculated from the major axis and the minor axis of primary particles of the boron nitride particle is 7 or less, and the thermally conductive resin composition layer has a thickness of 200 μm or less.

Insulation properties of a thermally conductive resin composition layer tend to be reduced when the amount of an inorganic filler is larger than a certain amount in order to achieve high heat-dissipation performance as described above. However, in the present invention, by using boron nitride particles having low aspect ratio, reduction of insulation properties can be prevented even after heating at high temperature in reflow soldering and the like, and for example, breakdown voltage can be increased. Thus, reduction of reliability after reflow can be prevented. The cause is not clear, but may be assumed as follows.

Boron nitride usually has hydrogen or a functional group such as a hydroxyl group at the terminal. However, those functional groups are unevenly distributed, with few of them on the main surface in the direction of the major axis of the primary particle of boron nitride and many on the end surface. This is assumed to be because the plane direction of a six-membered ring of, for example, hexagonal boron nitride, is on the main surface in the direction of the major axis. The main surface in the direction of the major axis has poor affinity to resin and is less compatible with resin due to the uneven distribution of functional groups described above, and thus boron nitride has poor followability to resin. Furthermore, although the above followability has little impact on insulation properties when the thermally conductive resin composition layer is as thick as more than 200 μm, the impact is large when the layer is thin with a thickness of 200 μm or less. By contrast, many functional groups exist on the end surface of the primary particle, and thus the surface has excellent affinity to resin, is highly compatible with resin, and also has excellent followability to resin. Thus, when the above aspect ratio is 7 or less, the ratio of the end surface is increased and the amount of portions which have good followability to resin is increased, and cracks are less likely to be formed around boron nitride particles even when the thermally conductive resin composition layer, which has a thickness of 200 μm or less and is susceptible to expansion and contraction due to heating in reflow and cooling thereafter, is expanded or contracted. As a result, reduction of insulation properties can be prevented after heating at high temperature in reflow soldering even when the thickness of the thermally conductive resin composition layer is reduced to about 200 μm or less. Cracks are easily formed around boron nitride particles when the amount of filling of filler is large and the amount of resin is small, and when the thermally conductive resin composition layer has a small thickness. By setting the aspect ratio to 7 or less, generation of cracks can be prevented well even when the amount of filling of filler is large.

By contrast, when the aspect ratio is more than 7, followability of boron nitride to resin is poor in many portions and thus a large number of cracks are formed due to heating in reflow and cooling thereafter when the thermally conductive resin composition layer is thin and the amount of filling of filler is large, and reduction of insulation properties cannot be sufficiently prevented.

The above aspect ratio is preferably 6.5 or less, and more preferably 6 or less in order to prevent reduction of insulation properties after heating in reflow and the like. The above aspect ratio is not particularly limited, and may be 1 or more, preferably 2 or more, and more preferably 5 or more from the viewpoint of improvement of thermal conductivity and availability of boron nitride particles.

Furthermore, the primary particle of the boron nitride particle has an average major axis measured in the cross-section of the thermally conductive resin composition layer of, for example, 1 μm or more and 20 μm or less, which is not particularly limited. When the primary particle of the boron nitride particle has an average major axis of 1 μm or more, thermal conductivity of the thermally conductive resin composition is likely to be improved. Furthermore, when the primary particle of the boron nitride particle has an average major axis of 20 μm or less, reduction of insulation properties after heating at high temperature in reflow and the like can be further prevented. The primary particle of the boron nitride particle has an average major axis of preferably 1.5 μm or more, and more preferably 2.0 μm or more, and preferably 15 μm or less, more preferably 10 μm or less, and preferably 6.0 μm or less from these points of view.

The average aspect ratio and the average major axis are determined based on the major axis and the minor axis of primary particles of the boron nitride particle measured in a cross-section exposed by a cross-section polisher. The detail is as follows.

First, a cross-section of the thermally conductive sheet is exposed by a cross-section polisher and the exposed cross-section is observed by a scanning electron microscope (SEM) at a magnification of 400 to 1,200 to obtain an observation image.

In the observation image, the major axis and the minor axis of 200 random primary particles of the boron nitride particle are measured using an image processing software to calculate the aspect ratio of the respective particles from the major axis/ the minor axis and determine the average of the 200 particles as an average aspect ratio; the major axis refers to the length of the longest portion of the primary particle of the boron nitride particle observed in the observation image, and the minor axis is the length in the direction perpendicular to the direction of the major axis in the observation image.

Any cross-section of the thermally conductive resin composition layer is to be exposed, but in a thermally conductive sheet, a cross-section in the thickness direction of the thermally conductive sheet is to be exposed.

It is preferable that the boron nitride particle comprises an agglomerated boron nitride particle as described above. The agglomerated boron nitride particle is agglomerated particles formed by agglomeration of primary particles. The primary particle of the boron nitride particle may be hexagonal boron nitride or cubic boron nitride, and hexagonal boron nitride is preferred. When hexagonal boron nitride is used and the average aspect ratio is set small as described above, compatibility with resin is improved and cracks are unlikely to be formed after heating at high temperature, making it easier to maintain good insulation properties. Although the shape of the primary particle is not particularly limited, it is preferable that the primary particle is flaky. Flaky particles include those which have small aspect ratio and are almost cubic.

Non- agglomerated boron nitride particles (i.e., a boron nitride single particle) are usually oriented when the

thermally conductive resin composition is molded into a pre-determined shape through various steps including press molding. For example, when the composition is molded into a sheet, non- agglomerated boron nitride particles are generally oriented in the plane direction. Thus, when a thermally conductive sheet having a thermally conductive resin composition layer made of a thermally conductive resin composition is prepared, it may be difficult to improve thermal conductivity in the thickness direction. Meanwhile, when boron nitride particles are used as in the present invention, orientation of boron nitride is prevented, and thermal conductivity in the thickness direction of, for example, the thermally conductive sheet described later, is easily increased.

Whether boron nitride particles are agglomerated particles or not may be usually determined by, for example, the above observation of cross-sections. Agglomerated boron nitride particles may maintain the agglomerated form or may be deformed, collapse or be disintegrated through various steps such as press molding. Agglomerated boron nitride particles are usually not oriented even when they are mixed with components constituting binder resin and then deformed, collapse or are disintegrated through a step such as press molding, and agglomerated boron nitride particles are present in a lump. Thus, observation of the cross-section described above suggests that particles are agglomerated boron nitride particles, enabling us to determine whether particles are agglomerated particles or not.

The agglomerated boron nitride particles added to the thermally conductive resin composition layer has an average particle size of preferably 5 μm or more, and more preferably 10 μm or more, and preferably 200 μm or less, more preferably 150 μm or less, and further preferably 100 μm or less in order to improve insulation properties and thermal conductivity efficiently.

The average particle size of agglomerated particles may be measured by a laser diffraction / scattering method. For the method of calculation of the average particle size, the particle size of agglomerated particles in the case where the cumulative volume is 50% (d50) is adopted as an average particle size.

The method for producing agglomerated boron nitride particles is not particularly limited, and the agglomerated boron nitride particles may be produced by a known method. For example, agglomerated boron nitride particles may be prepared by agglomerating (granulating) primary particles which have been previously prepared. Specific examples thereof include a spray drying method and a fluid bed granulation method. The spray drying method may be classified into a two-fluid nozzle method, a disc method (also called a rotary method) and an ultrasonic nozzle method and the like depending on the method of spraying. Any of these methods may be used.

In the method for producing agglomerated boron nitride particles, the step of granulation is not always necessary. For example, agglomerated boron nitride particles may be formed by natural agglomeration of primary particles of boron nitride during growth of boron nitride which has been crystallized by a known method.

An agglomerated boron nitride particle may be used singly, or two or more types of agglomerated boron nitride particles may be used. When two or more types of agglomerated boron nitride particles are used, the first agglomerated boron nitride particle whose primary particles have a relatively large average particle size and the second agglomerated boron nitride particle whose primary particles have an average particle size smaller than the first agglomerated boron nitride particle may be used in combination.

Furthermore, "UHP-G1H" made by SHOWA DENKO K.K., for example, may also be used as the agglomerated boron nitride particle. "UHP-G1H" and "HP-40" made by Mizushima Ferroalloy Co., Ltd. may be used in combination.

The thermally conductive resin composition layer may include the above agglomerated boron nitride particles alone as the boron nitride particle, but it may also include boron nitride single particles in addition to the above agglomerated boron nitride particles. The boron nitride single particle may be included to the extent that the effect of the present invention is not impaired. The content is, for example, less than 50 parts by volume, preferably less than 30 parts by volume, and more preferably less than 20 parts by volume based on 100 parts by volume of the agglomerated boron nitride particle.

When the boron nitride single particle is included, the average aspect ratio is calculated after selecting 200 particles randomly without distinguishing the boron nitride single particle (primary particle) from the primary particle of the agglomerated boron nitride particle.

The content of the boron nitride particle in the thermally conductive resin composition layer is, for example, 15% by volume or more and 80% by volume or less. The content of 15% by volume or more provides the thermally conductive resin composition layer with excellent thermal conductivity. The content of 80% by volume or less improves adhesiveness of the thermally conductive resin composition layer to a metal plate and the like, and increases peeling strength of the metal plate to a thermal conductive sheet in the laminate described later. The content of boron nitride is preferably 20% by volume or more, more preferably 30% by volume or more, and further preferably 40% by volume or more to improve thermal conductivity and insulation properties.

When the content of boron nitride particles is increased as described above, cracks are easily formed after heating at high temperature in reflow and the like, and it becomes difficult to maintain good insulation properties. However, in the present invention, excellent insulation properties can be maintained even after heating at high temperature by reducing the average aspect ratio of boron nitride particles as described above. The content of boron nitride is preferably 75% by volume or less, more preferably 67% by volume or less, and further preferably 65% by volume or less to improve

adhesiveness to a metal plate and the like.

(Inorganic filler other than boron nitride particle)

The thermally conductive resin composition layer according to the present invention may include an inorganic filler other than the boron nitride particle described above in addition to the boron nitride particle. A thermally conductive filler may be used as the inorganic filler other than the boron nitride particle. The thermally conductive filler has a thermal conductivity of, for example, 10 W/(m·K) or more, preferably 15 W/(m·K) or more, and more preferably 20 W/(m·K) or more. The upper limit of thermal conductivity of the thermally conductive filler is not particularly limited, and may be, for example, 300 W/(m·K) or less, and 200 W/(m·K) or less. The inorganic filler other than the boron nitride particle enters into the gap between boron nitride particles such as agglomerated boron nitride particles to improve thermal conductivity.
The thermal conductivity of the inorganic filler may be measured on the cross-section of the filler cut and processed by a cross-section polisher by using Thermal Microscope made by BETHEL Co., Ltd. by a periodically modulated thermoreflectance method.
Examples of the inorganic filler other than the boron nitride particle include alumina, aluminum nitride, magnesium oxide, diamond and silicon carbide. Use of the inorganic filler prevents reduction of insulation properties while maintaining good thermal conductivity, and makes it easier to improve adhesiveness to metal plates. Of the above substances, alumina is preferred from the viewpoint of thermal conductivity, an increased level of adhesiveness to metal plates and prevention of reduction of insulation properties.
One of the inorganic fillers other than the boron nitride particle may be used alone or two or more of them may be used in combination.
A filler having any shape may be used as the inorganic filler other than the boron nitride particle. A flaky, spherical, granular, amorphous or polygonal filler may be used, or agglomerated particles may be used. It is preferable that the primary particle of the inorganic filler other than the boron nitride particle has an aspect ratio of 3 or less. Such fillers include a spherical filler. Spherical alumina is preferred as the spherical filler. The average aspect ratio of the primary particle may be determined by observation of a cross-section as described above.
The inorganic filler other than the boron nitride particle has an average aspect ratio of preferably 2 or less. The inorganic filler other than the boron nitride particle may have an aspect ratio of 1 or more. Use of the inorganic filler other than the boron nitride particle having low aspect ratio makes it easier to improve thermal conductivity and adhesiveness to metal plates while preventing reduction of insulation properties after heating at high temperature.
The inorganic filler other than the boron nitride particle has an average particle size of preferably 0.1 μm or more, more preferably 0.2 μm or more, and further preferably 0.3 μm or more. The inorganic filler other than the boron nitride particle has an average particle size of preferably 100 μm or less, more preferably 80 μm or less, and further preferably 70 μm or less. When the average particle size is the upper limit or less, a large amount of the inorganic filler is easily mixed in the thermally conductive resin composition layer. When the average particle size is the lower limit or more, insulation properties may be easily improved. The average particle size of the inorganic filler other than the boron nitride particle may be measured by, for example, the Coulter Counter method.
One of the inorganic fillers other than the boron nitride particle may be used alone or two or more of them may be used in combination. When two or more fillers are used, the inorganic fillers of a different material, such as alumina and magnesium oxide, may be used, or two or more inorganic fillers having a different average particle size may be used. For the two or more inorganic fillers having a different average particle size, those of the same material, such as alumina, or those of a different material may be used.
When two or more inorganic fillers other than the boron nitride particle, which have a different average particle size, are used, an inorganic filler having an average particle size of more than 2 μm (hereinafter also referred to as an "inorganic filler having a large particle size") and an inorganic filler having an average particle size of 2 μm or less (hereinafter also referred to as an "inorganic filler having a small particle size") may be used. A combination use of the inorganic filler having a large particle size and the inorganic filler having a small particle size makes it easier to improve the filling ratio of the inorganic filler, and thus thermal conductivity can be easily improved. For the thermally conductive resin composition layer, the appearance of two or more peaks in the particle size distribution indicates inclusion of two or more inorganic fillers having a different particle size.
The inorganic filler having a large particle size has an average particle size of preferably 3 μm or more, and preferably 100 μm or less, more preferably 50 μm or less, and further preferably 35 μm or less. The inorganic filler having a small particle size has an average particle size of preferably 1.5 μm or less, and more preferably 1 μm or less, and preferably 0.1 μm or more, and more preferably 0.5 μm or more.
The ratio of the inorganic filler having a large particle size to the inorganic filler having a small particle size (inorganic filler having a large particle size / inorganic filler having a small particle size) in terms of volume is not particularly limited, and is 0.2 or more and 10 or less, preferably 0.5 or more and 8 or less, and more preferably 1 or more and 6 or less.
The content of the inorganic filler other than the boron nitride particle in the thermally conductive resin composition layer is, for example, 2% by volume or more and 60% by volume or less. When the content is 2% by volume or more, the effect of mixing the inorganic filler other than the boron nitride particle is high, and thermal conductivity and adhesiveness to metal plates can be improved while preventing reduction of insulation properties after heating. When the content is 60% by volume or less, a certain amount or more of boron nitride particles may be included in the thermally conductive resin composition layer, and thus insulation properties are less likely to be reduced even after heating at high temperature while the thermal conductivity of the thermally conductive resin composition layer is increased. The content of the inorganic filler other than the boron nitride particle in the thermally conductive resin composition layer is preferably 4% by volume or more, and more preferably 10% by volume or more from the above point of view. The content of the inorganic filler other than the boron nitride particle in the thermally conductive resin composition layer is preferably 55% by volume or less, and more preferably 45% by volume or less to include a certain amount or more of the boron nitride particle to ensure thermal conductivity.

When the inorganic filler other than the boron nitride particle is included, the ratio of the inorganic filler other than the boron nitride particle to the boron nitride particle in terms of volume (inorganic filler other than boron nitride particle / boron nitride particle) is, for example, 0.01 or more and 4 or less. The ratio in this range makes it easier to prevent reduction of insulation property due to heating while improving thermal conductivity and adhesiveness to metal plates. The above ratio is preferably 0.05 or more, more preferably 0.15 or more, and further preferably 0.3 or more, and preferably 3 or less, more preferably 2 or less, and further preferably 1 or less from the above point of view.

The content of the inorganic filler in the thermally conductive resin composition layer (i.e., the total amount of the boron nitride particle and the inorganic filler other than the boron nitride particle) is 65% by volume or more as described above. When the content is less than 65% by volume, the amount of filling of the inorganic filler cannot be large and high heat-dissipation performance cannot be obtained.

The content of the inorganic filler is preferably 80% by volume or less. When the content is 80% by volume or less, adhesiveness of the thermally conductive resin composition layer to metal plates is improved. The content of the inorganic filler is preferably 78% by volume or less, more preferably 75% by volume or less, and further preferably 70% by volume or less from such a point of view.

(Binder resin)

The thermally conductive resin composition layer includes a binder resin. The binder resin binds the inorganic fillers including the above boron nitride particles and maintains the thermally conductive resin composition layer in a predetermined shape, such as a sheet, as described later. The resin used for the thermally conductive resin composition layer is not particularly limited, and a thermoplastic resin, a thermosetting resin and the like may be used. Examples of thermoplastic resins include a styrene resin, a phenoxy resin, a phthalate resin, a thermoplastic urethane resin, a polyamide resin, a thermoplastic polyimide resin, a ketone resin and a norbornene resin. Examples of thermosetting resins include an amino resin such as a urea resin and a melamine resin, a phenol resin, a thermosetting urethane resin, an epoxy resin, a phenoxy resin, a thermosetting polyimide resin and an amino alkyd resin. One binder resin may be used alone or two or more of them may be used in combination for the thermally conductive resin composition layer.

Of the resins described above, an epoxy resin and a phenoxy resin are preferred. The epoxy resin and the phenoxy resin may be more preferably used as a thermosetting component which is cured by heating (a thermosetting resin). It is preferable that an epoxy resin is included in the present invention from the viewpoint of moldability. It is also preferred to use an epoxy resin and a phenoxy resin in combination.

<Epoxy resin>

Examples of epoxy resins include a compound having two or more epoxy groups in the molecule. The epoxy resin has a weight average molecular weight of less than 5,000.

Specific examples of epoxy resins include a styrene skeleton-containing epoxy resin, a bisphenol A epoxy resin, a bisphenol F epoxy resin, a bisphenol S epoxy resin, phenol novolac epoxy resin, a biphenol epoxy resin, a naphthalene epoxy resin, a biphenyl epoxy resin, a fluorene epoxy resin, a phenol aralkyl epoxy resin, a naphthol aralkyl epoxy resin, a dicyclopentadiene epoxy resin, an anthracene epoxy resin, an epoxy resin having an adamantane skeleton, an epoxy resin having a tricyclodecane skeleton, an epoxy resin having a triazine nucleus in the skeleton and a glycidyl amine epoxy resin.

The epoxy equivalent of the epoxy resin is not particularly limited, and the epoxy resin has an epoxy equivalent of, for example, 80 g/eq or more and 500 g/eq or less, preferably 90 g/eq or more and 400 g/eq or less, and more preferably 90 g/eq or more and 350 g/eq or less. The epoxy equivalent may be measured by the method according to JIS K 7236.

One of the above epoxy resins may be used alone, or two or more of them may be used in combination.

<Phenoxy resin>

The phenoxy resin is obtained by, for example, reacting epihalohydrin and a divalent phenol compound, or reacting a divalent epoxy compound and a divalent phenol compound. It is preferable that the above phenoxy resin has a bisphenol A skeleton, a bisphenol F skeleton, a bisphenol A/F mixed skeleton, a naphthalene skeleton, a fluorene skeleton, a biphenyl skeleton, an anthracene skeleton, a pyrene skeleton, a xanthene skeleton, an adamantane skeleton or a dicyclopentadiene skeleton. It is more preferable that the above phenoxy resin has a bisphenol A skeleton, a bisphenol F skeleton, a bisphenol A/F mixed skeleton, a naphthalene skeleton, a fluorene skeleton or a biphenyl skeleton. It is further preferable that the above phenoxy resin has a bisphenol A skeleton.

Furthermore, the phenoxy resin has a weight average molecular weight of, for example, 10,000 or more, preferably 20,000 or more, more preferably 30,000 or more, and preferably 1,000,000 or less, and more preferably 250,000 or less. Even when a resin having such a high molecular weight is used, it is easy to form a sheet by applying a diluted solution prepared by diluting a curable resin composition with a solvent. The weight average molecular weight is measured by gel permeation chromatography (GPC) in terms of polystyrene. In gel permeation chromatography (GPC), tetrahydrofuran may be used as an eluent.

The epoxy equivalent of the phenoxy resin is not particularly limited, and the phenoxy resin has an epoxy equivalent of, for example, 1,500 g/eq or more and 25,000 g/eq or less, preferably 2,000 g/eq or more and 20,000 g/eq or less, and more preferably 2,500 g/eq or more and 18,000 g/eq or less.

One of the above phenoxy resins may be used alone, or two or more of them may be used in combination.

<Curing agent>

It is preferable that the thermosetting resin (thermosetting component) described above is cured by a curing agent to be a binder resin in the thermally conductive resin composition layer. More specifically, while the thermally conductive resin composition layer according to the present invention may be formed by curing a curable resin composition including an inorganic filler such as boron nitride particles and a thermosetting component, it is preferable that the curable resin composition further includes a curing agent.

The curable resin composition as used herein means a resin composition before cured, and the curable resin composition may be cured to form a thermally conductive resin composition layer. The curable resin composition may also contain a curing accelerator described later or an additive other than the curing accelerator in addition to the above components. The curing agent reacts with a thermosetting component to form a binder resin. The total amount of the thermosetting component and the curing agent added to a curable resin composition may be regarded as the content of the binder resin in the thermally conductive resin composition layer.

When any one of an epoxy resin and a phenoxy resin is used as the thermosetting component, a cyanate ester compound (cyanate ester curing agent), an amine compound (amine curing agent), a thiol compound (thiol curing agent), a phosphine compound, dicyandiamide, a phenol compound (phenol curing agent), an acid anhydride, an active ester compound, a carbodiimide compound (carbodiimide curing agent) and a benzoxazine compound (benzoxazine curing agent) may be used as a curing agent. The above curing agent may have a functional group reactive with the epoxy group in the above epoxy resin or phenoxy resin.

A curing agent may be used alone or two or more of them may be used in combination.

It is preferable that the curable resin composition includes at least one of the above phenol compounds, a cyanate ester compound, acid anhydride, an active ester compound, a carbodiimide compound and a benzoxazine compound.

Examples of phenol compounds include novolac phenol, biphenol phenol, biphenylene phenol, naphthalene phenol, dicyclopentadiene phenol, aralkyl phenol and dicyclopentadiene phenol.

Examples of cyanate ester compounds include a novolac cyanate ester resin, a bisphenol cyanate ester resin and a prepolymer prepared by trimerizing part of them. Examples of novolac cyanate ester resins described above include a phenol novolac cyanate ester resin and an alkylphenol cyanate ester resin. Examples of bisphenol cyanate ester resins described above include a bisphenol A cyanate ester resin, a bisphenol E cyanate ester resin and tetramethyl bisphenol F cyanate ester resin.

Examples of commercially available products of the cyanate ester compound include phenol novolac cyanate ester resins ("PT-30" and "PT-60" made by Lonza KK.) and prepolymers prepared by trimerizing bisphenol cyanate ester resin ("BA230S", "BA-3000S," "BTP-1000S" and "BTP-6020S made by Lonza KK.).

Examples of acid anhydrides include tetrahydrophthalic anhydride and an alkylstyrene-maleic anhydride copolymer.

The active ester compound refers to a compound which contains at least one ester bond in the structure and in which an aromatic ring is bonded to both ends of the ester bond. The active ester compound is prepared by a condensation reaction of, for example, a carboxylic acid compound or a thiocarboxylic acid compound and a hydroxy

compound or a thiol compound.

The above carbodiimide compound has a structural unit represented by the following formula (1). In the following formula (1), the right end and the left end are a site to which another group is bonded. One of the above carbodiimide compounds may be used alone, or two or more of them may be used in combination. The structural unit represented by the following formula (1) may have two or more repeat units in a molecule.

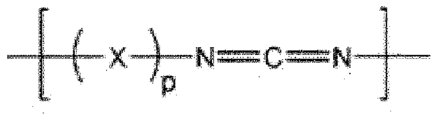

(1)

In the above formula (1), X represents an alkylene group, a group in which a substituent is bonded to an alkylene group, a cycloalkylene group, a group in which a substituent is bonded to a cycloalkylene group, an arylene group, a group in which a substituent is bonded to an arylene group, p represents an integer of 1 to 5. When a plurality of Xs exist, Xs may be the same or different.

In a preferred embodiment, at least one X is an alkylene group, a group in which a substituent is bonded to an alkylene group, a cycloalkylene group or a group in which a substituent is bonded to a cycloalkylene group.

Examples of commercially available products of the above carbodiimide compounds include "CARBODILITE V-02B," "CARBODILITE V-03," "CARBODILITE V-04K," "CARBODILITE V-07," "CARBODILITE V-09," "CARBODILITE 10MSP," and "CARBODILITE 10M-SP (modified)" made by Nisshinbo Chemical Inc., and "Stabaxol P," "Stabaxol P400" and "Hycasyl 510" made by Rhein Chemie.

Examples of benzoxazine compounds described above include P-d benzoxazine and F-a benzoxazine.

When a curing agent is used, the content of the curing agent based on the thermosetting component in terms of volume is not particularly limited as long as the thermosetting component is appropriately cured, and is for example, 0.1 or more and 0.8 or less, preferably 0.15 or more and 0.6 or less, and more preferably 0.2 or more and 0.5 or less.

The content of the binder resin described above is for example 10% by volume or more and 35% by volume or less. When the content is 10% by volume or more, the inorganic filler such as boron nitride particles is sufficiently bonded to give a thermally conductive resin composition layer having a desired form. Furthermore, when the content is 35% by volume or less, a certain amount or more of the inorganic filler such as boron nitride particles can be included, and thus insulation properties are increased and thermal conductivity can be improved.

The content of the binder resin is preferably 20% by volume or more, more preferably 22% by volume or more, further preferably 30% by volume or more, and preferably 34% by volume or less.

When the above thermosetting component is used, a curing accelerator may also be used as described above. Using the curing accelerator increases the curing speed and allows the curing resin composition to be cured fast, and makes the cross-linking structure in the thermally conductive resin composition layer uniform. Furthermore, the number of unreacted functional groups is reduced and consequently the cross-linking density is increased.

The curing accelerator is not particularly limited and a known curing accelerator may be used. Specific examples thereof include an anionic curing accelerator such as an imidazole compound, a cationic curing accelerator such as an amine compound, an organic metal compound such as a phosphorus compound, a curing accelerator other than the anionic or the cationic curing accelerator, and a radical curing accelerator such as peroxide. The content of the curing accelerator is for example 0.1 to 8% by volume, and preferably 0.3 to 5% by volume.

One of the curing accelerators may be used alone or two or more of them may be used in combination.

The thermally conductive resin composition layer according to the present invention may also include other additives such as a dispersant, a coupling agent such as a silane coupling agent, a flame retardant, an antioxidant, an ion scavenger, a tackifier, a plasticizer, a thixotropic agent and a colorant in addition to the above components.

The thermally conductive resin composition layer according to the present invention is composed of a single layer of a thermally conductive resin composition. Furthermore, it is preferable that the thermally conductive resin composition layer according to the present invention is cured when the layer includes a thermosetting component, but the layer may be semi-cured or uncured.

<Thermally conductive sheet>

The thermally conductive sheet of the present invention has a thermally conductive resin composition layer comprising a thermally conductive resin composition (hereinafter also referred to as "the thermally conductive resin composition layer according to the present invention"). In the following, the thermally conductive sheet will be described in more detail. The thermally conductive resin composition layer is as described in the section of the thermally conductive resin composition. Thus, the thermally conductive resin composition layer comprises an inorganic filler comprising boron nitride particles and a binder resin, and may comprise an inorganic filler other than the boron nitride particle. Details of

them are as described in the above section of the thermally conductive resin composition layer. The content of the respective components of the thermally conductive resin composition layer is the same as the content of the respective components of the thermally conductive resin composition layer described above.

While the thermally conductive sheet has the thermally conductive resin composition layer according to the present invention as described above, it may have a single layer of the thermally conductive resin composition layer. When the sheet has a single layer of the thermally conductive resin composition layer, excellent insulation properties can be maintained after heating at high temperature over the whole thickness of the thermally conductive sheet, and thus reduction of insulation properties can be reliably prevented.

It is also preferable that the thermally conductive sheet has multiple resin layers. When the thermally conductive sheet has multiple resin layers, at least one of the resin layers may be the thermally conductive resin composition layer according to the present invention. Furthermore, two or more resin layers contain boron nitride particles, and in that case, it is preferable that all of the resin layers containing boron nitride particles are the thermally conductive resin composition layer according to the present invention. This configuration allows all of the resin layers containing boron nitride particles to have high heat-dissipation performance and maintain good insulation properties even when the sheet is heated at high temperature in reflow and the like, and reduction of insulation properties can be reliably prevented even with the multilayer structure. It is more preferable that when the thermally conductive sheet has multiple resin layers, all of the resin layers are made of the thermally conductive resin composition according to the present invention.

The thermally conductive resin composition layer according to the present invention has a thickness of 200 μm or less, preferably 180 μm or less, and more preferably 150 μm or less. The thermally conductive resin composition layer has a thickness of, for example, 50 μm or more, preferably 70 μm or more, and more preferably 100 μm or more, although the thickness is not particularly limited. A thickness of the thermally conductive resin composition layer in the above range prevents reduction of insulation properties even when a large amount of filler is included, and provides excellent heat-dissipation properties. When the thermally conductive sheet has a single layer of the thermally conductive resin composition layer, the thickness of the above thermally conductive resin composition layer is the thickness of the thermally conductive sheet.

A thermally conductive sheet in which the thermally conductive resin composition layer is as thick as more than 200 μm is unlikely to be affected by cracks formed by heating in reflow and the subsequent cooling, and thus such a sheet does not have the problem in the present invention of reduction of insulation properties. Setting the thickness of the thermally conductive resin composition layer to the above range in the thermally conductive sheet of the present invention prevents reduction of insulation properties even when the filler is densely filled, and provides excellent heat-dissipation properties.

When the thermally conductive sheet has multiple resin layers, the sheet has a thickness of, for example, 500 μm or less, although the thickness is not particularly limited. Setting the thickness to 500 μm or less enables thinning of the thermally conductive sheet, which is more specifically a circuit board and a semiconductor device described later. The thermally conductive sheet has a thickness of preferably 300 μm or less, more preferably 250 μm or less, and further preferably 200 μm or less, and still more preferably 180 μm or less. The thermally conductive sheet has a thickness of, for example, 40 μm or more, and preferably 60 μm or more to ensure insulation properties.

The thermally conductive sheet has a thermal conductivity of preferably 10 W/(m·K) or more. A thermal conductivity of 10 W/(m·K) or more improves heat-dissipation properties and enables heat generated in elements mounted on a circuit board to be released to the outside efficiently. This can prevent an excessive increase of temperature even when an element from which a large amount of heat is released, such as a power element used in a power module and the like, is mounted. The thermally conductive sheet has a thermal conductivity of more preferably 11 W/(m·K) or more, further preferably 12 W/(m·K) or more, and still more preferably 15 W/(m·K) or more. Although the upper limit of the thermal conductivity of the thermally conductive sheet is not particularly limited, the upper limit is practically about 25 W/(m·K). The thermal conductivity of the thermally conductive sheet may be measured in the direction of the thickness by a laser flash method.

<Laminate>

As shown in Fig. 2, the laminate of the present invention is a laminate 13 comprising the above thermally conductive sheet 10, a metal base plate 11 and a metal plate 12, and the laminate 13 comprises the thermally conductive sheet 10 and the metal plate 12 on the metal base plate 11 in this order.

It is preferable that the metal base plate 11 and the metal plate 12 have a thermal conductivity of 10 W/(m·K) or more to have function of a thermal conductor. Examples of materials used for them include metal such as aluminum, copper, gold and silver, and a graphite sheet. Aluminum, copper and gold are preferred, and aluminum and copper are more preferred to improve thermal conductivity more efficiently.

The metal base plate 11 has a thickness of preferably 0.1 to 5 mm, and the metal plate 12 has a thickness of 10 to 2,000 μm, and more preferably 10 to 900 μm. The metal plate also includes a plate such as a copper plate and

foil such as copper foil.

It is preferable that the laminate 13 is used as a circuit board. It is preferable that when the laminate is used as a circuit board, the metal plate 12 in the laminate 13 has a circuit pattern. For the circuit pattern, circuit may be appropriately patterned depending on the element mounted on the circuit board. The circuit pattern may be formed by, for example, etching, although the method is not particularly limited. Furthermore, in the circuit board, the metal base plate 11 is used as a heat-dissipation plate and the like.

<Semiconductor device>

The present invention also provides a semiconductor device comprising the above laminate. More specifically, the semiconductor device 15 comprises a laminate 13 comprising a thermally conductive sheet 10, a metal base plate 11 and a metal plate 12, and a semiconductor element 14 provided on the metal plate 12 of the laminate 13. The metal plate 12 may be patterned by etching and the like to have a circuit pattern.

Although two semiconductor elements 14 are shown in Fig. 3, the number of the semiconductor elements 14 is not particularly limited as long as the semiconductor device has one or more semiconductor elements. Furthermore, electronic parts other than the semiconductor element 14, such as a transistor (not shown), may also be mounted on the metal plate 12. The semiconductor element 14 is connected to the metal plate 12 through a conductive part for connection 16 formed on the metal plate 12. The conductive part for connection 16 may be formed by soldering. A sealing resin 19 is provided on the surface of the laminate 13 on the metal plate 12 side. At least the semiconductor element 14 may be sealed with the sealing resin 19, and the metal plate 12 may be sealed with the sealing resin 19 together with the semiconductor element 14.

It is preferable that at least one semiconductor element 14 is a power element (i.e., a power semiconductor element), although this is not particularly limited. Thus, it is preferable that the semiconductor device 15 is a power module. Power modules are used in, for example, an inverter.

Furthermore, power modules are used in an industrial equipment such as an elevator and an uninterruptible power supply (UPS), but the purpose of use is not particularly limited.

A lead 20 is connected to the metal plate 12. The lead 20 is extended to the outside from the sealing resin 19 and connects the metal 12 to external devices. Wire 17 may be connected to the semiconductor element 14. As shown in Fig. 3, the wire 17 may connect the semiconductor element 14 to another semiconductor element 14, the metal plate 12, lead 20 and the like.

Heat is generated in the semiconductor element 14 when the semiconductor element 14 is operated by supplying electric power thereto through lead 20 and the like, and the heat generated in the semiconductor element 14 is transferred to the metal base plate 11 through the thermally conductive sheet 10 and released from the metal base plate 11. The metal base plate 11 may be connected to a heat sink having heat-dissipation fins as necessary.

The semiconductor device 15 may be produced through the step of reflow in the method of production. More specifically, in the method for producing the semiconductor device 15, a laminate 13 is first prepared, and a conductive part for connection 16 is formed on the metal plate 12 of the laminate 13 by solder printing, and a semiconductor element 14 is mounted on the conductive part for connection 16. Then, the laminate 13 on which the semiconductor element 14 is mounted is passed through a reflow furnace and heated in the reflow furnace to connect the semiconductor element 14 to the metal plate 12 with the conductive part for connection 16. The temperature in the reflow furnace is not particularly limited, and for example about 200 to 300°C. In the method for producing the semiconductor device 15, a sealing resin 19 may be stacked on the laminate 13 after the step of reflow to seal the semiconductor element 14. Before sealing with the sealing resin 19, wire 17, lead 20 and the like are appropriately installed.

The above shows an embodiment in which the semiconductor element 14 is connected to the metal plate 12 in the step of reflow, but the method is not limited to such an embodiment, and the laminate 13 (i.e., a circuit board) may be connected to another substrate (not shown) in the step of reflow.

In the present invention, the thermally conductive sheet 10 has excellent insulation properties, and even after heating at high temperature, the sheet has excellent insulation properties as described above. Thus, in the thermally conductive sheet 10, excellent insulation properties are maintained between the metal plate 12 and the metal base plate 11 even after the step of reflow, and therefore breakdown voltage is increased and the sheet becomes highly reliable.

Furthermore, an increased thermal conductivity of the thermally conductive sheet 10 as described above allows heat generated in the semiconductor element 14 to be suitably released even when the semiconductor element 14 is a power element and a large amount of heat is generated in operation, preventing malfunction or breakdown of the semiconductor element 14 without an increase in the temperature of the semiconductor element 14 during operation. Furthermore, since adhesiveness between the metal plate 12 and the thermally conductive sheet 10 can be increased in the laminate 13, the semiconductor device 15 has better performance.

(Method for producing thermally conductive resin composition layer, thermally conductive sheet and laminate)

When the thermally conductive resin composition layer includes a thermosetting component (thermosetting resin) as a raw material of binder resin, the thermally conductive resin composition layer may be prepared by adding, for example, boron nitride particles such as agglomerated boron nitride particles, and at least one of a curing agent, an inorganic filler and an additive if necessary, to a thermosetting component and mixing them to prepare a curable resin composition, and then curing the curable resin composition.

At that stage the curable resin composition may be molded in the form of a sheet. The composition may be applied to or laminated on a support such as a separation sheet to be molded in the form of a sheet. When a laminate is produced, the curable resin composition may be applied to or laminated on a metal base plate to be molded in the form of a sheet. As used herein, the sheet refers to a thin and flat form whose thickness is small for the length and width. Those formed on another member such as a support or a metal base plate in the form of a film or a layer also fall into the category of the sheet.

The curable resin composition molded on a support in the form of a sheet may be released from the support after or before curing. The above curable resin composition may be diluted with a solvent for dilution and then applied to a support, a metal base plate and the like and then dried.

It is preferable that the curable resin composition molded in the form of a sheet by application or lamination is cured by heating and pressurizing in press molding and the like to be formed into a thermally conductive resin composition layer or a thermally conductive sheet. The whole or part of the curable resin composition may be cured before press molding. Furthermore, when the thermally conductive sheet has a multilayer structure of 2 or more resin layers, a plurality of resin layers may be previously molded and the resin layers may be laminated to form a multilayer structure.

When a laminate comprising a thermally conductive sheet, a metal base plate and a metal plate is produced, a curable resin composition which has been previously molded in the form of a sheet is disposed between the metal base plate and the metal plate, and the material is heated and pressurized in press molding to bond the metal base plate to the metal plate with the curable resin composition (thermally conductive resin composition layer) therebetween to produce a laminate. It is preferable that the curable resin composition is cured by heating in press molding, while the whole or part of the curable resin composition may be cured before press molding.

When the curable resin composition is disposed between the metal base plate and the metal plate, two or more sheets of the curable resin composition may be disposed between the metal base plate and the metal plate to form a multilayer structure having a plurality of the thermally conductive resin composition layers according to the present invention. Furthermore, one or more sheets of the curable resin composition and one or more resin layers containing no boron nitride particles may be disposed between the metal base plate and the metal plate to form a multilayer structure having a resin layer different from the thermally conductive resin composition layer according to the present invention.

A laminate may also be prepared by applying the curable resin composition to a metal base plate or laminating it thereon and then stacking a metal plate thereon, and thereafter heating and pressurizing in press molding where necessary to bond the metal base plate to the metal plate with the curable resin composition (thermally conductive resin composition layer) therebetween. In this case two or more sheets of the curable resin composition may be disposed on the metal base plate to form a multilayer structure having a plurality of the thermally conductive resin composition layers according to the present invention. Alternatively, one or more sheets of the curable resin composition and one or more resin layers containing no boron nitride particles may be disposed to form a multilayer structure having a resin layer different from the thermally conductive resin composition layer according to the present invention.

Furthermore, when the binder resin is a thermoplastic resin, the thermally conductive resin composition and the laminate may be produced by the same method as described except for omitting curing.

Examples

Hereinafter the present invention will be described in detail with reference to Examples and Comparative Examples, but the present invention is not limited thereto.

Methods of measurement and evaluation of properties are as follows.

[Average aspect ratio and average major axis of boron nitride particle]

A cross-section parallel to the thickness direction of the thermally conductive composition layer (thermally conductive sheet) prepared in Examples and Comparative Example was exposed by a cross-section polisher and the cross-section was observed by a scanning electron microscope at a magnification of 400 to 1,200 to obtain an observation image. In the observation image, the major axis and the minor axis of 200 random primary particles of the boron nitride particle were measured using an image processing software "WinROOF2015" (made by Mitani Corporation) to calculate the average aspect ratio and the average major axis. The results are shown in Table 1. At that stage, the thermally

conductive resin composition layer is divided into quarters in the vertical direction, and the major axis and the minor axis of 50 primary particles were measured in the four respective regions divided and the average aspect ratio and the average major axis were calculated.

The laminates prepared in Examples and Comparative Examples were evaluated by the following methods.

[Initial breakdown voltage (Initial BDV)]

The laminates prepared in Examples and Comparative Examples were cut into 90 mm × 50 mm and the metal plate was patterned in a pattern of ϕ 20 mm by etching to give a test sample. Then AC voltage was applied to the metal plate and the metal base plate of the test sample using a withstand voltage tester ("MODEL 7473" made by EXTECH Electronics Co., Ltd.) so that the voltage was increased at a rate of 20 kV/ min. The voltage at which the value of current was 10 mA (breakdown voltage) was determined as an initial BDV.

[BDV after reflow]

The laminates prepared in Examples and Comparative Examples were left in a thermostatic chamber at 285°C for 5 minutes. The breakdown voltage measured in the same manner as described above was determined as a BDV after reflow.

[Rate of Decrease of BDV]

The rate of decrease of BDV was calculated by the following equation from the resulting initial BDV and BDV after reflow, and was evaluated by the following criteria.

$$\text{Rate of decrease of BDV (\%)} = (\text{initial BDV} - \text{BDV after reflow}) / \text{initial BDV} \times 100$$

AA: Rate of decrease of BDV less than 4%
A: Rate of decrease of BDV 4% or more and less than 8%
B: Rate of decrease of BDV 8% or more and less than 12%
C: Rate of decrease of BDV 12% or more

[Peeling strength]

The laminates prepared in Examples and Comparative Examples were cut into 50 mm × 120 mm to give a test sample. The copper foil of the test sample was peeled off while leaving only 10-mm wide thereof at the center. The peel strength to the 10-mm wide copper foil of 35 μm was measured according to JIS C 6481.

"Tensilon universal tester" made by Orientec Co., Ltd. was used as an apparatus for measuring the above peeling strength. The angle of peeling was 90°. The peeling strength was evaluated by the following criteria.

[Criteria for peeling strength]

AA: Peeling strength 8 N/cm or more
A: Peeling strength 4 N/cm or more and less than 8 N/cm
B: Peeling strength 2 N/cm or more and less than 4 N/cm
C: Peeling strength less than 2 N/cm

[Thermal conductivity]

Thermal conductivity of a measurement sample prepared by cutting the laminate prepared in Examples and Comparative Examples into a 1-cm square and spraying carbon black on both surfaces was measured by a laser flush method using a measurement apparatus "Nanoflash" (made by NETZSCH, Model No. LFA447).

[Thermal resistance]

Thermal resistance was calculated using the thermal conductivity obtained and was evaluated by the following criteria.

$$\text{Thermal resistance } [(m^2 \cdot \mu K)/W] = \text{resin layer thickness } [\mu m] \ / \ \text{thermal conductivity } [W/m \cdot K]$$

[Criteria for evaluating thermal resistance]

A: Thermal resistance less than 10 $(m^2 \cdot \mu K)/W$
B: Thermal resistance 10 $(m^2 \cdot \mu K)/$ W or more and 16 $(m^2 \cdot \mu K)/W$ or less
C: Thermal resistance more than 16 $(m^2 \cdot \mu K)/W$

[Example 1]

A curable resin composition was prepared by mixing the components shown in Table 1 based on the blend shown in Table 1. Next, the curable resin composition was applied to a PET releasing sheet (thickness 40 μm) and pre-cured by heating in an oven at 50°C for 10 minutes. Next, the pre-cured sheet-shaped curable resin composition was released from the PET releasing sheet and was sandwiched between copper foil (thickness 35 μm) corresponding to the metal plate, and an aluminum plate (thickness 1.0 mm) corresponding to the metal base plate, and heated at a temperature of 110°C for 30 minutes to be further pre-cured to give a pre-cured laminate. The resulting pre-cured laminate was vacuum pressed under conditions of a temperature of 190°C and a pressure of 15 MPa for 120 minutes to cure the curable resin composition to give a laminate having a metal base plate, a thermally conductive composition layer (thermally conductive sheet) and a metal plate. The thermally conductive resin composition layer had a thickness of 150 μm. The results of evaluation of the resulting laminates are shown in Table 1.

[Examples 2 to 12, Comparative Examples 1 to 8]

Laminates were prepared in the same manner as in Example 1 except for changing the blend of the curable resin composition to those shown in Table 1.

[Table 1]

| | | | Examples | | | | | | | | | | | | Comparative Examples | | | | | | | |
|---|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 1 | 2 | 3 | 4 | 5 | 6 | 7 | 8 |
| Curable resin composition (% by volume) | Thermosetting component | | 26.0 | 26.0 | 26.0 | 18.4 | 14.5 | 18.4 | 18.4 | 18.4 | 18.4 | 26.0 | 26.0 | 26.0 | 26.0 | 26.0 | 26.0 | 26.0 | 26.0 | 26.0 | 26.0 | 26.0 |
| | Curing agent | | 6.0 | 6.0 | 6.0 | 4.2 | 3.4 | 4.2 | 4.2 | 4.2 | 4.2 | 6.0 | 6.0 | 6.0 | 6.0 | 6.0 | 6.0 | 6.0 | 6.0 | 6.0 | 6.0 | 6.0 |
| | Curing accelerator | | 2.0 | 2.0 | 2.0 | 1.4 | 1.1 | 1.4 | 1.4 | 1.4 | 1.4 | 2.0 | 2.0 | 2.0 | 2.0 | 2.0 | 2.0 | 2.0 | 2.0 | 2.0 | 2.0 | 2.0 |
| | Dispersant | | 1 | 1 | 1 | 1 | 1 | 1 | 1 | 1 | 1 | 1 | 1 | 1 | 1 | 1 | 1 | 1 | 1 | 1 | 1 | 1 |
| | BN agglomerated particle (1) | UHP-G1H | 65 | 58.5 | 32.5 | 75 | 80 | 55 | 27.5 | 70 | 20 | 20 | 65 | 65 | 6.5 | | | | | | 65 | |
| | | HP-40 | | | | | | | | | | | | | | 65 | | | | | | 65 |
| | | PTCL5MHF | | | | | | | | | | | | | | | 65 | | | | | |
| | | PTX-60S | | | | | | | | | | | | | | | | 65 | | | | |
| | | AC6091 | | | | | | | | | | | | | | | | | 65 | | | |
| | | PTX-25 | | | | | | | | | | | | | | | | | | 65 | | |
| | BN agglomerated particle (2) | HP-40 | | 6.5 | 32.5 | | | | 27.5 | | | | | | 58.5 | | | | | | | |
| | Alumina | CB-A30S | | | | | | 15 | 15 | 4 | 40 | 30 | | | | | | | | | | |
| | | CB-P02 | | | | | | 5 | 5 | 1 | 15 | 15 | | | | | | | | | | |
| Amount of boron nitride added (% by volume) | | | 65 | 65 | 65 | 75 | 80 | 55 | 55 | 70 | 20 | 20 | 65 | 65 | 65 | 65 | 65 | 65 | 65 | 65 | 65 | 65 |
| Total amount of filler (% by volume) | | | 65 | 65 | 65 | 75 | 80 | 75 | 75 | 75 | 75 | 65 | 65 | 65 | 65 | 65 | 65 | 65 | 65 | 65 | 65 | 65 |
| Ratio of mixing of BN agglomerated particle [(1) : (2)] | | | 100:0 | 90:10 | 50:50 | 100:0 | 100:0 | 100:0 | 50:50 | 100:0 | 100:0 | 100:0 | 100:0 | 100:0 | 10:90 | 100:0 | 100:0 | 100:0 | 100:0 | 100:0 | 100:0 | 100:0 |
| Average aspect ratio of BN agglomerated particle | | | 5.7 | 5.9 | 6.5 | 5.7 | 5.7 | 5.7 | 6.5 | 5.7 | 5.7 | 5.7 | 5.7 | 5.7 | 7.2 | 7.4 | 9.7 | 10.4 | 7.6 | 11.2 | 5.7 | 7.4 |
| Average major axis of BN agglomerated particle [μm] | | | 4.7 | 5.3 | 7.5 | 4.7 | 4.7 | 4.7 | 7.5 | 4.7 | 4.7 | 4.7 | 4.7 | 4.7 | 9.7 | 10.3 | 9.1 | 10.0 | 14.7 | 13.0 | 4.7 | 10.3 |
| Thickness of resin composition layer [μm] | | | 150 | 150 | 150 | 150 | 150 | 150 | 150 | 150 | 150 | 150 | 120 | 200 | 150 | 150 | 150 | 150 | 150 | 150 | 250 | 250 |

(continued)

| | Examples | | | | | | | | | | | | Comparative Examples | | | | | | | |
|---|---|---|---|---|---|---|---|---|---|---|---|---|---|---|---|---|---|---|---|---|
| | 1 | 2 | 3 | 4 | 5 | 6 | 7 | 8 | 9 | 10 | 11 | 12 | 1 | 2 | 3 | 4 | 5 | 6 | 7 | 8 |
| Initial BDV [kV] | 12.8 | 13.4 | 13.8 | 2.8 | 2.5 | 12.8 | 13.2 | 3.5 | 11.5 | 12.1 | 8.1 | 15.1 | 14.0 | 14.3 | 11.4 | 8.7 | 11.2 | 6.0 | 16.2 | 18.1 |
| BDV after reflow [kV] | 12.4 | 12.5 | 12.5 | 2.7 | 2.3 | 12.6 | 12.3 | 3.3 | 11.4 | 11.9 | 7.6 | 14.8 | 12.0 | 11.8 | 8.7 | 5.3 | 6.0 | 1.7 | 16.0 | 16.6 |
| Rate of decrease of BDV after reflow [%] | 3.1 | 6.7 | 9.4 | 3.6 | 8.0 | 1.6 | 6.8 | 5.7 | 0.9 | 1.7 | 6.2 | 2.0 | 14.3 | 17.5 | 23.7 | 39.1 | 46.4 | 71.7 | 1.2 | 8.3 |
| | AA | A | B | AA | B | AA | A | A | AA | AA | A | AA | C | C | C | C | C | C | AA | B |
| Peeling strength [N/cm] | 4.3 | 4.3 | 4.2 | 2.3 | 2.3 | 6.0 | 6.0 | 3.2 | 7.1 | 7.4 | 4.3 | 4.3 | 4.1 | 4 | 0.8 | 1.1 | 3.2 | 1 | 4.3 | 4 |
| | A | A | A | B | B | A | A | B | A | A | A | A | A | A | C | C | B | C | A | A |
| Thermal conductivity [W/(m·k)] | 13.2 | 14.0 | 13.0 | 19.3 | 20.1 | 16.2 | 15.3 | 17.0 | 11.0 | 10.4 | 13.2 | 13.2 | 13.0 | 11.7 | 6.8 | 13.7 | 8.6 | 9.0 | 13.2 | 11.7 |
| Thermal resistance [(m$^2$·μK)/W] | 11.4 | 10.7 | 11.5 | 7.8 | 7.5 | 9.3 | 9.8 | 8.8 | 13.6 | 14.4 | 9.1 | 15.2 | 11.5 | 12.8 | 22.1 | 10.9 | 17.4 | 16.7 | 18.9 | 21.4 |
| | B | B | B | A | A | A | A | A | B | B | A | B | B | B | C | B | C | C | C | C |

The components in Table 1 are as follows.

(Thermosetting components)

Epoxy resin: "YX-4000" made by Japan Epoxy Resins Co., Ltd.
Phenoxy resin: "jER-1256" made by Japan Epoxy Resins Co., Ltd.

* In Examples and Comparative Examples, the epoxy resin and the phenoxy resin were used at a volume ratio of 6/7 (epoxy resin/ phenoxy resin) as the thermosetting component.

(Curing agent)

"MEH-7851-S" made by Showa Kasei Kogyo Co., Ltd.

(Curing accelerator)

"2MZA-PW" made by Shikoku Chemicals Corporation

(Dispersant)

"ED151" made by Kusumoto Chemicals, Ltd.

(Boron Nitride (BN) agglomerated particle)

UHP-G1H: "UHP-G1H" made by SHOWA DENKO K.K., an average particle size of agglomerated particle being 33 μm
HP-40: "HP-40" made by Mizushima Ferroalloy Co., Ltd., an average particle size of agglomerated particle being 40 μm
PTCL5MHF: "PTCL5MHF" made by SAINT-GOBAIN, an average particle size of agglomerated particle being 100 μm
PTX60S: "PTX60S" made by Momentive, an average particle size of agglomerated particle being 60 μm
AC6091: "AC6091" made by Momentive, an average particle size of agglomerated particle being 125 μm
PTX25: "PTX25" made by Momentive, an average particle size of agglomerated particle being 25 μm

(Alumina)

CB-A30S: "CB-A30S" made by SHOWA DENKO K.K., spherical alumina having an average particle size of 28 μm
CB-P02: "CB-P02" made by SHOWA DENKO K.K., spherical alumina having an average particle size of 2 μm

As is clear from the results in Table 1, in Examples, when a thermally conductive resin composition including a large amount of inorganic filler contains boron nitride particles and boron nitride has an average aspect ratio of 7 or less, the rate of decrease of BDV is small even when the thermally conductive resin composition layer is thin, and excellent initial insulation properties are maintained even after heating at high temperature.
By contrast, in Comparative Examples 1 to 6, since the thermally conductive resin composition layer was thin and boron nitride particles had an average aspect ratio of more than 7, the rate of decrease of BDV was high and initial insulation properties were not maintained after heating at high temperature even though the thermally conductive resin composition includes boron nitride particles. Furthermore, in Comparative Examples 7 and 8, although the rate of decrease of BDV was small because the thermally conductive resin composition layer was thick, thermal resistance increased and thus it was difficult to ensure good heat dissipation properties.

Reference Signs List

1 Thermally conductive resin composition

2 Boron nitride particle
3 Binder resin
4 Inorganic filler other than boron nitride particle
10 Thermally conductive sheet
11 Metal base plate
12 Metal plate
14 Semiconductor element
15 Semiconductor device
16 Conductive part for connection
17 Wire
19 Sealing resin
20 Lead

## Claims

**1.** A thermally conductive sheet comprising a thermally conductive resin composition layer,

the thermally conductive resin composition layer comprising an inorganic filler and a binder resin,
the inorganic filler comprising a boron nitride particle, a content of the inorganic filler in the thermally conductive resin composition layer being 65% by volume or more, the boron nitride particle having an average aspect ratio of 7 or less, which is calculated from a major axis and a minor axis of a primary particle measured by the following method,
the thermally conductive resin composition layer having a thickness of 200 μm or less:
(Method of measurement)
a cross-section in a thickness direction of the thermally conductive sheet is exposed by a cross-section polisher and the exposed cross-section is observed by a scanning electron microscope (SEM) at a magnification of 400 to 1,200 to obtain an observation image; in the observation image, the major axis and the minor axis of 200 random primary particles of the boron nitride particle in the thermally conductive resin composition layer are measured using an image processing software to calculate an aspect ratio of the respective particles from the major axis/ the minor axis, and an average of the 200 particles is determined as an average aspect ratio; the major axis refers to a length of the longest portion of the primary particle of the boron nitride particle observed in the observation image, and the minor axis is a length in a direction perpendicular to a direction of the major axis in the observation image.

**2.** The thermally conductive sheet according to claim 1, wherein the thermally conductive resin composition layer comprises an inorganic filler other than the boron nitride particle.

**3.** The thermally conductive sheet according to claim 2, wherein the inorganic filler other than the boron nitride particle is at least one selected from the group consisting of alumina, aluminum nitride, magnesium oxide, diamond and silicon carbide.

**4.** The thermally conductive sheet according to any one of claims 1 to 3, wherein a content of the boron nitride particle in the thermally conductive resin composition layer is 15% by volume or more and 80% by volume or less.

**5.** The thermally conductive sheet according to any one of claims 1 to 4, wherein the primary particle of the boron nitride particle has an average major axis measured in the cross-section of the thermally conductive resin composition layer of 1 μm or more and 20 μm or less.

**6.** The thermally conductive sheet according to any one of claims 1 to 5, wherein the boron nitride particle comprises an agglomerated boron nitride particle.

**7.** The thermally conductive sheet according to any one of claims 1 to 6, wherein the thermally conductive sheet has a thermal conductivity of 10 W/(m·K) or more.

**8.** A laminate comprising the thermally conductive sheet according to any one of claims 1 to 7, a metal base plate and a metal plate, wherein the laminate comprises the thermally conductive sheet and the metal plate on the metal base plate in this order.

**9.** The laminate according to claim 8, wherein the laminate is a circuit board.

**10.** The laminate according to claim 8 or 9, wherein the metal plate has a circuit pattern.

**11.** A semiconductor device comprising the laminate according to any one of claims 8 to 10, and a semiconductor element provided on the metal plate.

**12.** A thermally conductive resin composition layer comprising an inorganic filler and a binder resin,

the inorganic filler comprising a boron nitride particle, a content of the inorganic filler in the thermally conductive resin composition layer being 65% by volume or more, the boron nitride particle having an average aspect ratio of 7 or less, which is calculated from a major axis and a minor axis of a primary particle measured by the following method,

the thermally conductive resin composition layer having a thickness of 200 $\mu$m or less:

(Method of measurement)

a cross-section of the thermally conductive resin composition layer is exposed by a cross-section polisher and the exposed cross-section is observed by a scanning electron microscope (SEM) at a magnification of 400 to 1,200 to obtain an observation image; in the observation image, the major axis and the minor axis of 200 random primary particles of the boron nitride particle in the thermally conductive resin composition layer are measured using an image processing software to calculate an aspect ratio of the respective particles from the major axis/ the minor axis, and an average of the 200 particles is determined as an average aspect ratio; the major axis refers to a length of the longest portion of the primary particle of the boron nitride particle observed in the observation image, and the minor axis is a length in a direction perpendicular to a direction of the major axis in the observation image.

Fig.1

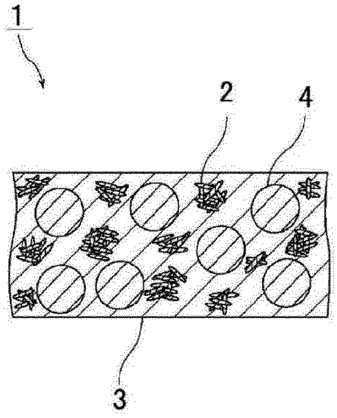


Fig.2

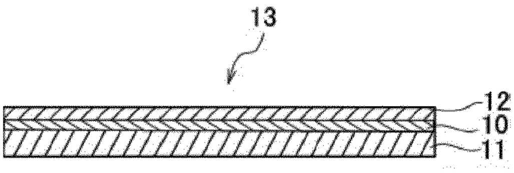


Fig.3

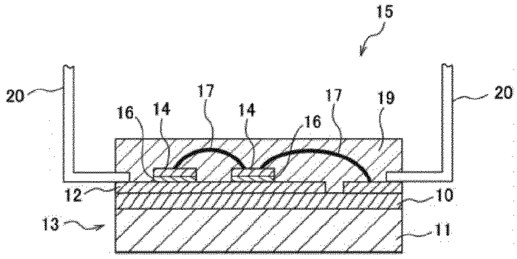

**INTERNATIONAL SEARCH REPORT**

International application No. PCT/JP2021/001728

A. CLASSIFICATION OF SUBJECT MATTER
H01L 23/36(2006.01)i; H01L 23/373(2006.01)i; C08K 7/04(2006.01)i; C08L 101/00(2006.01)i; C09K 5/14(2006.01)i; C08K 3/013(2018.01)i; C08K 3/38(2006.01)i
FI: H01L23/36 D; C08K3/38; C08K3/013; C08K7/04; H01L23/36 M; C08L101/00; C09K5/14 E
According to International Patent Classification (IPC) or to both national classification and IPC

B. FIELDS SEARCHED
Minimum documentation searched (classification system followed by classification symbols)
H01L23/36; H01L23/373; C08K7/04; C08L101/00; C09K5/14; C08K3/013; C08K3/38

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P, Y | JP 2020-102556 A (SEKISUI CHEMICAL CO., LTD.) 02 July 2020 (2020-07-02) paragraphs [0010]-[0099], fig. 1, 2 | 1-12 |
| Y | WO 2018/207821 A1 (SEKISUI CHEMICAL CO., LTD.) 15 November 2018 (2018-11-15) paragraphs [0020]-[0122], fig. 1-4 | 1-12 |
| Y | WO 2018/235919 A1 (SEKISUI CHEMICAL CO., LTD.) 27 December 2018 (2018-12-27) paragraphs [0030]-[0163] fig. 1-3 | 1-12 |
| A | WO 2014/199550 A1 (MITSUBISHI ELECTRIC CORP.) 18 December 2014 (2014-12-18) entire text, all drawings | 1-12 |

☐ Further documents are listed in the continuation of Box C.   ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 15 March 2021 (15.03.2021) | 30 March 2021 (30.03.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/001728

| Patent Documents referred in the Report | Publication Date | Patent Family | Publication Date |
|---|---|---|---|
| JP 2020-102556 A | 02 Jul. 2020 | (Family: none) | |
| WO 2018/207821 A1 | 15 Nov. 2018 | US 2020/0090831 A1 paragraphs [0023]-[0140], fig. 1-4<br>EP 3624138 A1<br>CN 110603609 A<br>KR 10-2020-0005527 A | |
| WO 2018/235919 A1 | 27 Dec. 2018 | EP 3644353 A1 paragraphs [0030]-[0163], fig. 1-3<br>CN 110546758 A<br>KR 10-2020-0023264 A | |
| WO 2014/199650 A1 | 18 Dec. 2014 | US 2016/0115343 A1 entire text, all drawings<br>CN 105308125 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018082165 A
- JP 2019151754 A